# EUROPEAN PATENT APPLICATION

(11) **EP 4 492 926 A1**
(43) Date of publication of application: **15.01.2025**
(21) Application number: 23766581.5
(22) Date of filing: 24.02.2023
(51) Int. Cl.: H05K 1/03, H05K 3/46

(54) **PRINTED CIRCUIT BOARD HAVING BUILT-IN THICK CONDUCTOR AND METHOD FOR MANUFACTURING SAME**

(30) Priority: 07.03.2022 JP 2022034641
(71) Applicant: Panasonic Intellectual Property Management Co., Ltd., Kadoma-shi, Osaka 571-0057 (JP)
(72) Inventor: AOKI, Tomoyuki, Kadoma-shi 571-0057 Osaka (JP); SAITO, Eiichiro, Kadoma-shi 571-0057 Osaka (JP)
(74) Representative: Appelt, Christian W.
(86) International application number: PCT/JP2023/006665
(87) International publication number: WO 2023/171403

(57) **Abstract**

A thick conductor built-in type printed wiring board (1) includes a printed wiring board (21), a first baseless insulating layer (31), a second baseless insulating layer (32), and a base-containing insulating layer (4). The printed wiring board (21) includes an insulating layer (211) and a conductor (212) disposed on one surface in a thickness direction of the insulating layer (211) and having a thickness (T212) of greater than or equal to 100 µm and less than or equal to 500 µm. The first baseless insulating layer (31) covers the insulating layer (211) and the conductor (212) and includes no base material. The second baseless insulating layer (32) covers the first baseless insulating layer (31), includes no base material, not having a melting point of lower than or equal to 230°C, and has a thickness (T32) of greater than or equal to 3 µm and less than or equal to 25 µm. The base-containing insulating layer (4) covers the second baseless insulating layer (32) and includes a base material (40).

## Description

### Technical Field

The present disclosure generally relates to thick conductor built-in type printed wiring boards and methods for manufacturing the thick conductor built-in type printed wiring boards and specifically relates to a thick conductor built-in type printed wiring board including a conductor having a thickness of greater than or equal to 100 µm therein and a method for manufacturing the thick conductor built-in type printed wiring board.

### Background Art

Patent Literature 1 discloses a thick conductor built-in type printed wiring board. The thick conductor built-in type printed wiring board includes a printed wiring board, an insulating resin layer, an insulating base material layer, and a conductor layer.

Here, the printed wiring board includes an insulating layer and a circuit provided on one surface or both surfaces of the insulating layer, the insulating layer including a cured product of a first resin composition, the circuit including a plurality of conductor wirings each having a thickness ranging from 105 µm to 630 µm, inclusive. Moreover, the insulating resin layer covers a surface of the printed wiring board on which the circuit is provided, the insulating resin layer including a cured product of a second resin composition and no fibrous base material. Further, the insulating base material layer covers the insulating resin layer, the insulating base material layer including a cured product of a third resin composition and a fibrous base material. Furthermore, the conductor layer covers the insulating base material layer. Meanwhile, the thick conductor built-in type printed wiring board does not include a void having a diameter of more than or equal to 10 µm therein.

The thick conductor built-in type printed wiring board of Patent Literature 1 makes it possible to keep excellent electrical insulation properties even when an electronic component is mounted by reflow soldering. In particular, it can be inferred that the thick conductor built-in type printed wiring board of Patent Literature 1 is excellent in electrical insulation properties in a planar direction.

The thick conductor built-in type printed wiring board of Patent Literature 1 is, however, still susceptible to an improvement in electrical insulation property in a thickness direction. For example, a so-called cloth touch is still susceptible to a further reduction. Note that the cloth touch will be described later.

### Citation List

### Patent Literature

Patent Literature 1: JP 2018-113423 A

### Summary of Invention

An object of the present disclosure is to provide: a thick conductor built-in type printed wiring board configured to suppress a cloth touch from occurring and to improve an electrical insulation property in a thickness direction as well as an electrical insulation property in a planar direction; and a method for manufacturing the thick conductor built-in type printed wiring board.

A thick conductor built-in type printed wiring board according to an aspect of the present disclosure includes: a printed wiring board including an insulating layer and a conductor disposed on one surface in a thickness direction of the insulating layer and having a thickness of greater than or equal to 100 µm and less than or equal to 500 µm; a first baseless insulating layer covering the insulating layer and the conductor and including no base material; a second baseless insulating layer covering the first baseless insulating layer, including no base material, not having a melting point of lower than or equal to 230°C, having a thickness of greater than or equal to 3 µm and less than or equal to 25 µm; and a base-containing insulating layer covering the second baseless insulating layer and including a base material.

A thick conductor built-in type printed wiring board according to another aspect of the present disclosure includes: a first printed wiring board including a first insulating layer and a first conductor disposed on one surface in a thickness direction of the first insulating layer and having a thickness of greater than or equal to 100 µm and less than or equal to 500 µm; a first baseless insulating layer covering the first insulating layer and the first conductor and including no base material; a second baseless insulating layer covering the first baseless insulating layer, including no base material, not having a melting point of lower than or equal to 230°C, and having a thickness of greater than or equal to 3 µm and less than or equal to 25 µm, a base-containing insulating layer covering the second baseless insulating layer and including a base material; a third baseless insulating layer covering the base-containing insulating layer, including no base material, not having a melting point of lower than or equal to 230°C, and having a thickness of greater than or equal to 3 µm and less than or equal to 25 µm; a fourth baseless insulating layer covering the third baseless insulating layer and including no base material; and a second printed wiring board including a second insulating layer covered with the fourth baseless insulating layer and a second conductor disposed on a surface of the second insulating layer, the surface facing the fourth baseless insulating layer, the second conductor being covered with the fourth baseless insulating layer and having a thickness of greater than or equal to 100 µm and less than or equal to 500 µm.

A method for manufacturing a thick conductor built-in type printed wiring board according to an aspect of the present disclosure includes: a step (A1) of overlapping a first baseless film including no base material, a second baseless film including no base material, not having a melting point of lower than or equal to 230°C, and having a thickness of greater than or equal to 3 µm and less than or equal to 25 µm, a base-containing sheet including a base material, and a metal foil in this order on a printed wiring board to form a laminated body, and a step (B1) of integrating the laminated body by heating and compressing the laminated body disposed between hot plates. The printed wiring board includes an insulating layer and a conductor disposed on one surface in a thickness direction of the insulating layer and having a thickness of greater than or equal to 100 µm and less than or equal to 500 µm. In the step (A1), the insulating layer of the printed wiring board and the conductor are disposed to face the first baseless film.

A method for manufacturing a thick conductor built-in type printed wiring board according to another aspect of the present disclosure includes a step (A2) of overlapping, on a first printed wiring board, a first baseless film including no base material, a second baseless film including no base material, not having a melting point of lower than or equal to 230°C, and having a thickness of greater than or equal to 3 µm and less than or equal to 25 µm, a base-containing sheet including a base material, a third baseless film including no base material, not having a melting point of lower than or equal to 230°C, and having a thickness of greater than or equal to 3 µm and less than or equal to 25 µm, a fourth baseless film including no base material, and a second printed wiring board in this order to form a laminated body; and a step (B2) of integrating the laminated body by heating and compressing the laminated body disposed between hot plates. The first printed wiring board includes a first insulating layer and a first conductor disposed on one surface in a thickness direction of the first insulating layer and having a thickness of greater than or equal to 100 µm and less than or equal to 500 µm. The second printed wiring board includes a second insulating layer and a second conductor disposed on one surface in a thickness direction of the second insulating layer and having a thickness of greater than or equal to 100 µm and less than or equal to 500 µm. In the step (A2), the first insulating layer of the first printed wiring board and the first conductor are disposed to face the first baseless film, and the second insulating layer of the second printed wiring board and the second conductor are disposed to face the fourth baseless film.

### Brief Description of Drawings

FIG. 1 is a schematic sectional view of a thick conductor built-in type printed wiring board according to a first embodiment;
FIG. 2 is a schematic sectional view of a step in a method for manufacturing the thick conductor built-in type printed wiring board;
FIG. 3 is a schematic sectional view of another example of the thick conductor built-in type printed wiring board;
FIG. 4 is a schematic sectional view of a variation of the thick conductor built-in type printed wiring board;
FIG. 5 is a schematic sectional view of a thick conductor built-in type printed wiring board according to a second embodiment; and
FIG. 6 is a schematic sectional view of a step in a method for manufacturing the thick conductor built-in type printed wiring board according to the second embodiment.

### Description of Embodiments

### 1. Overview

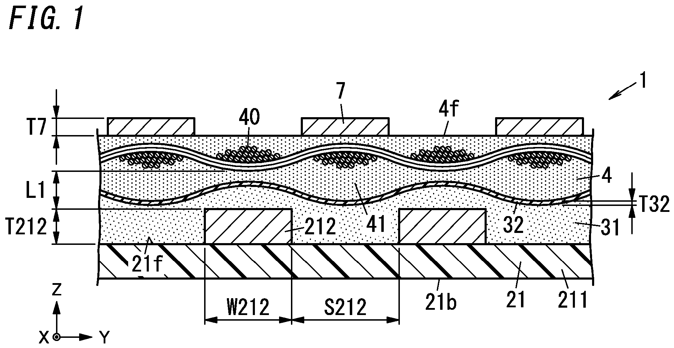

As shown in FIG. 1, a thick conductor built-in type printed wiring board 1 according to the present embodiment is a printed wiring board including a thick conductor therein. Here, the thick conductor means a conductor 212 having a thickness T212 of greater than or equal to 100 µm. Therefore, the thick conductor built-in type printed wiring board 1 is appropriately used as a so-called large current substrate. The large current substrate is a substrate capable of handling a current larger than a current handled by a normal printed wiring board. Examples of applications of the large current substrate include, but are not particularly limited to, automobiles, power distribution panels of factories, mechanical tools, industrial machinery, electric railcars, and robots.

As described above, since the large current substrate allows a large current to flow through the thick conductor, a so-called cloth touch can be a problem. The cloth touch means that a base material (mainly glass cloth) comes into contact with the thick conductor. When the cloth touch occurs, conductive anodic filament (CAF) tends to be induced. The CAP is a type of copper migration and means a migration advancing along the base material. When the CAP advances, a short circuit is more likely to be formed. To solve such problems, the inventors intensively studied and have consequently completed the thick conductor built-in type printed wiring board 1 as described below.

That is, as shown in FIG. 1, the thick conductor built-in type printed wiring board 1 according to the present embodiment includes a printed wiring board 21, a first baseless insulating layer 31, a second baseless insulating layer 32, and a base-containing insulating layer 4. One of features of the thick conductor built-in type printed wiring board 1 according to the present embodiment is that the thick conductor built-in type printed wiring board 1 includes the second baseless insulating layer 32. The second baseless insulating layer 32 is disposed between the conductor 212 and a base material 40, thereby reducing the chances that the conductor 212 and the base material 40 come into contact with each other. That is, the cloth touch is suppressed from occurring.

Thus, the present embodiment enables an electrical insulation property in a thickness direction (Z-axis direction) as well as an electrical insulation property in a planar direction (X-Y plane direction) to be improved.

### 2. Details

With reference to the drawings, the thick conductor built-in type printed wiring board 1 according to a first embodiment and a second embodiment will be described below. Drawings are schematic views, and the size of each component in the figures do not necessarily reflect actual dimension. In the figures, respective arrows specifying X-, Y-, and Z-axes are shown. However, these arrows are shown for the sake of description, are not intended to limit the direction of the thick conductor built-in type printed wiring board 1, and are without entities. The X-, Y-, and Z-axes are orthogonal to one another.

Further, in the following description, the "planar direction" means the "X-Y plane direction", the "thickness direction" means the "Z-axis direction", a "plan view" means a view along the Z-axis direction, and "a front view" means a view along the X-axis direction. To facilitate understanding, "one surface in the thickness direction" may be restated as an "upper surface", "the other surface in the thickness direction" may be restated as a "lower surface".

### (1) First Embodiment

### (1.1) Thick Conductor Built-in Type Printed Wiring Board

First of all, the thick conductor built-in type printed wiring board 1 according to the present embodiment will be described with reference to FIG. 1.

As shown in FIG. 1, the thick conductor built-in type printed wiring board 1 includes the printed wiring board 21, the first baseless insulating layer 31, the second baseless insulating layer 32, and the base-containing insulating layer 4. The thick conductor built-in type printed wiring board 1 may further include an external conductor(s) 7. Thus, the thick conductor built-in type printed wiring board 1 can be multilayered. The printed wiring board 21, the first baseless insulating layer 31, the second baseless insulating layer 32, the base-containing insulating layer 4, and the external conductor 7 will be sequentially described below.

### <Printed Wiring Board>

The printed wiring board 21 is a substrate which can be a core material. The printed wiring board 21 includes an insulating layer 211 and conductors 212.

### «Insulating Layer»

The insulating layer 211 is in the form of a layer parallel to the X-Y plane and having an electrical insulation property. Note that in the present specification, "parallel" includes not only being exactly parallel but also being substantially parallel as long as the effect of the present embodiment is not impaired.

The insulating layer 211 includes a cured product of a resin composition. The insulating layer 211 may further include a base material (omitted in FIG. 1). Note that when the insulating layer 211 include the base material, the base material is preferably not in contact with the conductors 212. Examples of the base material include, but are not particularly limited to, the base material 40 which will be described later.

The resin composition contains, for example, a thermosetting resin. The resin composition may further include at least any of a curing agent, a curing accelerator, an inorganic filler, or a flame retardant.

Examples of the thermosetting resin include, but are not particularly limited to, an epoxy resin, a polyimide resin, a phenolic resin, and a bismaleimide triazine resin.

Examples of the curing agent include, but are not particularly limited to, a diamine-based curing agent, a bifunctional or more phenol curing agent, an acid anhydride-based curing agent, dicyandiamide, and a low molecular weight polyphenylene ether compound. Examples of the diamine-based curing agent include, but are not particularly limited to, primary amine and secondary amine.

Examples of the curing accelerator include, but are not particularly limited to, an imidazole compound, a tertiary amine compound, an organic phosphine compound, and metal soap. Examples of the imidazole-based compound include, but are not particularly limited to, 2-ethyl - 4-methylimidazole (2E4MZ).

Examples of the inorganic filler include, but are not particularly limited to, silica, a molybdenum compound, aluminum hydroxide, magnesium hydroxide, aluminum silicate, magnesium silicate, talc, clay, and mica. Examples of the molybdenum compound include, but are not particularly limited to, molybdenum trioxide.

When the resin composition contains the inorganic filler, the content of the inorganic filler is preferably greater than or equal to 30 parts by mass and less than or equal to 500 parts by mass with respect to 100 parts by mass of the resin composition.

Examples of the flame retardant include, but are not particularly limited to, a halogen-based flame retardant and a non-halogen-based flame retardant. Examples of the halogen-based flame retardant include, but are not particularly limited to, a bromine-containing compound. Examples of the non-halogen-based flame retardant include, but are not particularly limited to, a phosphorus-containing compound and a nitrogen-containing compound.

### <<Conductor>>

The conductors 212 are disposed on one surface 21f (an upper surface 21f) in the thickness direction of the insulating layer 211. The conductors 212 form a circuit. The pattern of the circuit in plan view is not particularly limited.

The thickness T212 of each conductor 212 is greater than or equal to 100 µm and less than or equal to 500 µm, and preferably greater than or equal to 175 µm and less than or equal to 420 µm. When the thickness T212 of each conductor 212 is greater than or equal to 100 µm, a large current easily flows through each conductor 212. When the thickness T212 of each conductor 212 is less than or equal to 500 µm, a void is less likely to be left between adjacent ones of the conductors 212.

At least part of the conductors 212 included in the printed wiring board 21 preferably has a conductor width W212 of greater than or equal to 0.1 mm and less than or equal to 100 mm, and more preferably greater than or equal to 0.4 mm and less than or equal to 60 mm. When the conductor width W212 is greater than or equal to 0.1 mm, a large current easily flows through the conductor 212. When the conductor width W212 is less than or equal to 100 mm, the density can be increased. Note that the conductor width W212 means the width of a single conductor 212. That is, the conductor width W212 corresponds to the line (L) of line and space (L/S).

A conductor gap S212 is preferably more than or equal to 2 times and less than or equal to 10 times the conductor width W212, and more preferably more than or equal to 3 times and less than or equal to 10 times the conductor width W212. When the conductor gap S212 is more than or equal to 2 times the conductor width W212, an electrical insulation property between adjacent ones of the conductors 212 can be secured. When the conductor gap S212 is less than or equal to 10 times the conductor width W212, the cloth touch can be suppressed from occurring. Note that the conductor gap S212 means a width corresponding to an insulation part between adjacent ones of the conductors 212. That is, the conductor gap S212 corresponds to the space (S) of the L/S.

Examples of a material for the conductors 212 include, but are not particularly limited to, copper (Cu), silver (Ag), and palladium (Pd).

### <First Baseless Insulating Layer>

The first baseless insulating layer 31 is a layer including no base material and having an electrical insulation property. Here, examples of the base material not included in the first baseless insulating layer 31 include, but are not particularly limited to, the base material 40 which will be described later.

The first baseless insulating layer 31 is in a cured state (C stage). The first baseless insulating layer 31 covers the printed wiring board 21. Specifically, the first baseless insulating layer 31 covers the upper surface 21f of the insulating layer 211 and the conductors 212. The conductors 212 are buried in the first baseless insulating layer 31. The first baseless insulating layer 31 fills a gap between the conductors 212.

The first baseless insulating layer 31 is formed from the same material as the insulating layer 211 (except for the base material) of the printed wiring board 21.

### <Second Baseless Insulating Layer>

The second baseless insulating layer 32 is a layer including no base material and having an electrical insulation property. Here, examples of the base material not included in the second baseless insulating layer 32 include, but are not particularly limited to, the base material 40 which will be described later.

The second baseless insulating layer 32 covers the first baseless insulating layer 31. The second baseless insulating layer 32 faces the conductors 212 via the first baseless insulating layer 31 in the thickness direction. The first baseless insulating layer 31 does not have to be present between the second baseless insulating layer 32 and the conductors 212. In other words, the second baseless insulating layer 32 may be in contact with the conductors 212.

In FIG. 1, the second baseless insulating layer 32 is shown in wave form in a front view. That is, the second baseless insulating layer 32 is in wave form such that the second baseless insulating layer 32 is downward convex toward the insulating layer 211 at a location(s) where no conductor(s) 212 is disposed on the upper surface 21f of the insulating layer 211, and the second baseless insulating layer 32 is upward convex to be away from the insulating layer 211 at a location(s) where the conductor(s) 212 is disposed on the upper surface 21f of the insulating layer 211. Note that the second baseless insulating layer 32 may be parallel to the insulating layer 211.

The second baseless insulating layer 32 does not have a melting point of lower than or equal to 230°C. In other words, the second baseless insulating layer 32 does not have to have a fixed melting point or may have a melting point of higher than 230°C.

When the second baseless insulating layer 32 has a melting point of higher than 230°C, the melting point of the second baseless insulating layer 32 is preferably higher than 230°C and lower than or equal to 400°C.

The second baseless insulating layer 32 has a thickness T32 of greater than or equal to 3 µm and less than or equal to 25 µm, preferably greater than or equal to 10 µm and less than or equal to 25 µm. When the thickness T32 of the second baseless insulating layer 32 is greater than or equal to 3 µm, the electrical insulation property in the thickness direction can be improved. When the thickness T32 of the second baseless insulating layer 32 is less than or equal to 25 µm, the thick conductor built-in type printed wiring board 1 can be thinned.

Preferably, the second baseless insulating layer 32 includes at least one selected from the group consisting of polyimide (PI), aramid (aromatic polyamide), and polyphenylene sulfide (PPS). The second baseless insulating layer 32 including at least one of these substances is strong and has an enhanced electrical insulation property even when the second baseless insulating layer 32 is a thin film having a thickness T32 of less than or equal to 25 µm. In particular, the second baseless insulating layer 32 including the polyimide has low thermal expansion and excellent heat resistance. Moreover, the second baseless insulating layer 32 including the aramid has excellent alkali resistance. Further, the second baseless insulating layer 32 including the polyphenylene sulfide has excellent chemical resistance.

### <Base-Containing Insulating Layer>

The base-containing insulating layer 4 is a layer including at least one or more sheets of (in the present embodiment, one sheet of) the base material 40 and a cured resin layer 41 and having an electrical insulation property. Thus, since the base-containing insulating layer 4 includes the base material 40, the thermal expansion of the thick conductor built-in type printed wiring board 1 is reduced, thereby improving dimensional stability. The base-containing insulating layer 4 covers the second baseless insulating layer 32.

### «Base Material»

The base material 40 can be a reinforcement member for reinforcing the thick conductor built-in type printed wiring board 1. The base material 40 has a sheet shape and is disposed parallel to the X-Y plane. The base material 40 may be woven cloth or unwoven cloth. The weaving of the woven cloth may be plain weaving or twill weaving. Examples of the woven cloth include, but are not particularly limited to, glass cloth. The glass cloth may be subjected to opening treatment and/or coupling treatment.

The base material 40 can include inorganic fibers and/or organic fibers.

Examples of the inorganic fibers include, but are not particularly limited to, glass fiber. Examples of the composition of the glass fiber include, but are not particularly limited to, E glass, D glass, S glass, NE glass, T glass, Q glass, and quartz.

Examples of the organic fiber include, but are not particularly limited to, aramid fiber, polyparaphenylene benzobisoxazole (PBO) fiber, polybenzimidazole (PBI) fiber, polytetrafluoroethylene (PTFE) fiber, poly-para-phenylenebenzobisthiazole (PBZT) fiber, and totally aromatic polyester fiber.

### <<Cured Resin Layer>>

The cured resin layer 41 is formed from the same material as the insulating layer 211 of the printed wiring board 21. The cured resin layer 41 is in a cured state (C stage). The base material 40 is buried in the cured resin layer 41. The cured resin layer 41 includes a resin impregnated in the base material 40. The base material 40 faces the second baseless insulating layer 32 via the cured resin layer 41 in the thickness direction. The cured resin layer 41 does not have to be present between the base material 40 and the second baseless insulating layer 32. In other words, the base material 40 may be in contact with the second baseless insulating layer 32.

### <<Others>>

A distance L1 in the thickness direction between each conductor 212 and the base material 40 included in the base-containing insulating layer 4 is preferably greater than or equal to 3 µm, and more preferably greater than or equal to 10 µm. An upper limit value of the distance L1 is, for example, but is not particularly limited to, less than or equal to 400 µm. When the distance L1 is greater than or equal to 3 µm, the cloth touch is further suppressed from occurring. That is, the chances that the base material 40 comes into contact with the conductors 212 are reduced. This suppresses a path for a current from being formed.

### <External Conductor>

The external conductor 7 is disposed on an opposite surface 4f (an upper surface 4f) of the base-containing insulating layer 4 from the second baseless insulating layer 32. The external conductor 7 is formed from the same material as the conductors 212 of the printed wiring board 21. The external conductor 7 forms a circuit. The pattern of the circuit in plan view is not particularly limited. The external conductor 7 is preferably out of contact with the base material 40 included in the base-containing insulating layer 4.

The external conductor 7 may be interlayer-coupled to the conductors 212. The external conductor 7 may be on the other surface 21b (a lower surface 21b) in the thickness direction of the insulating layer 211 (not shown in FIG. 1). The external conductor 7 has a thickness T7 which may be equal to, or different from, the thickness T212 of each conductor 212.

### <Operation and Advantages>

The present embodiment enables the cloth touch to be suppressed from occurring and enables the electrical insulation property in the thickness direction (the Z-axis direction) as well as the electrical insulation property in the planar direction (the X-Y plane direction) to be improved. That is, the thick conductor built-in type printed wiring board 1 according to the present embodiment includes the second baseless insulating layer 32 disposed between the base material 40 and the conductors 212 as shown in FIG. 1. Thus, the second baseless insulating layer 32 blocks contact between the base material 40 and the conductors 212. That is, the cloth touch is suppressed from occurring.

Thus, the present embodiment enables the electrical insulation property in the thickness direction (the Z-axis direction) as well as the electrical insulation property in the planar direction (the X-Y plane direction) to be improved.

Here, if the first baseless insulating layer 31 and the cured resin layer 41 of the base-containing insulating layer 4 were in contact with each other, the thick conductor built-in type printed wiring board 1 would have a large plate thickness deviation or would have color unevenness.

In the present embodiment, however, the second baseless insulating layer 32 blocks the contact between the first baseless insulating layer 31 and the cured resin layer 41 of the base-containing insulating layer 4, and therefore, the thick conductor built-in type printed wiring board 1 can have a reduced plate thickness deviation and suppressed color unevenness. Note that the presence or absence of the color unevenness can be determined by observing the thick conductor built-in type printed wiring board 1 in plan view.

### (1.2) Method for Manufacturing Thick Conductor Built-in Type Printed Wiring Board

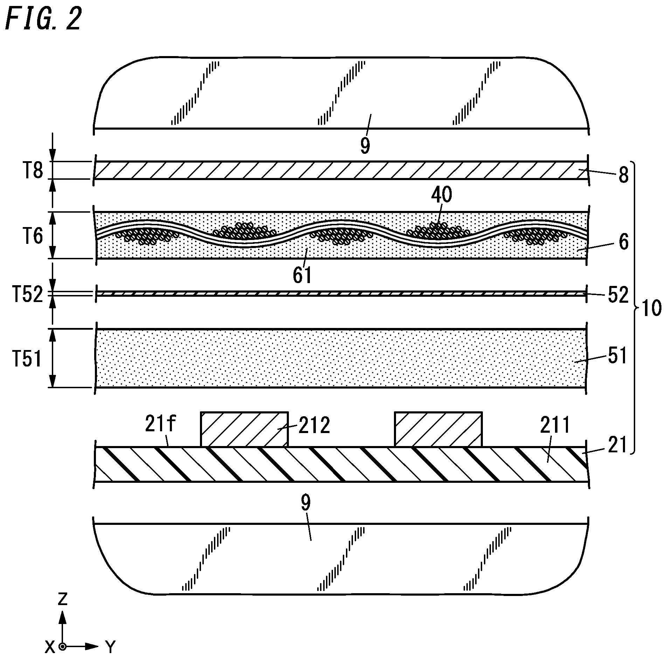

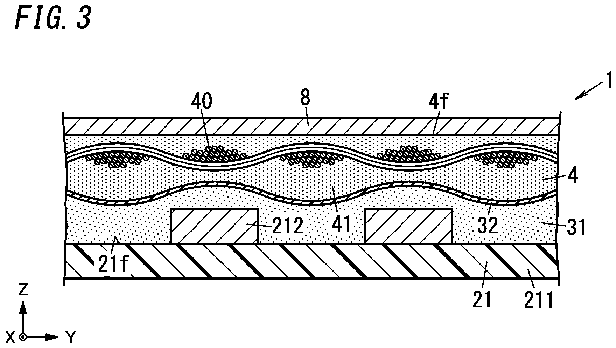

Next, a method for manufacturing the thick conductor built-in type printed wiring board 1 according to the present embodiment will be described with reference to FIGS. 2 and 3.

The method for manufacturing the thick conductor built-in type printed wiring board includes a step (A1) and a step (B1). The method for manufacturing the thick conductor built-in type printed wiring board may further include a step (C1).

### <Step (A1)>

As shown in FIG. 2, a first baseless film 51, a second baseless film 52, a base-containing sheet 6, and a metal foil 8 are overlapped in this order on the printed wiring board 21 to form a laminated body 10. The printed wiring board 21, the first baseless film 51, the second baseless film 52, the base-containing sheet 6, and the metal foil 8 will be sequentially described below.

### <<Printed Wiring Board>>

The printed wiring board 21 has already been described. As shown in FIG. 2, the upper surface 21f of the printed wiring board 21 is disposed to face the first baseless film 51. That is, in the step (A1), the upper surface 21f of the insulating layer 211 of the printed wiring board 21 and the conductors 212 are disposed to face the first baseless film 51.

### <<First Baseless Film>>

The first baseless film 51 is a film for forming the first baseless insulating layer 31. Thus, the first baseless film 51 is a film including no base material. The first baseless film 51 is different from the first baseless insulating layer 31 in that the first baseless film 51 is in a semi-cured state (B stage). The first baseless film 51 has a thickness T51 of preferably greater than or equal to "the thickness T212 of the conductor 212 × (1 - residual copper rate)" µm and less than or equal to "the thickness T212 of the conductor 212" µm, more preferably greater than or equal to "the thickness T212 of the conductor 212 × (1 - residual copper rate) × 1.2" µm and less than or equal to "the thickness T212 of the conductor 212" µm, depending on the thickness T212 of each conductor 212. Note that the residual copper rate = (the area of the pattern of a circuit formed by the conductors 212 in plan view/the area of the printed wiring board 21 in plan view).

### <<Second Baseless Film>>

The second baseless film 52 is a film for forming the second baseless insulating layer 32. Thus, the second baseless film 52 includes no base material. Moreover, the second baseless film 52 does not have a melting point of lower than or equal to 230°C. In other words, the second baseless film 52 does not have to have a fixed melting point or may have a melting point of higher than 230°C.

When the second baseless film 52 has a melting point higher than 230°C, the melting point of the second baseless film 52 is preferably higher than 230°C and lower than or equal to 400°C.

The second baseless film 52 has a thickness T52 of greater than or equal to 3 µm and less than or equal to 25 µm, and preferably greater than or equal to 10 µm and less than or equal to 25 µm. Thus, as long as the second baseless film 52 is not heated at a temperature higher than or equal to the melting point, the thickness T52 of the second baseless film 52 is substantially equal to the thickness T32 of the second baseless insulating layer 32.

### <<Base-containing Sheet>>

The base-containing sheet 6 is a sheet including the base material 40 and a semi-cured resin layer 61. The base-containing sheet 6 is a sheet for forming the base-containing insulating layer 4. Examples of the base-containing sheet 6 include, but are not particularly limited to, a prepreg.

The semi-cured resin layer 61 is in a semi-cured state (B stage). That is, when the semi-cured resin layer 61 is heated and a curing reaction advances, the semi-cured resin layer 61 becomes the cured resin layer 41. The base material 40 is buried in the semi-cured resin layer 61. The semi-cured resin layer 61 includes a resin impregnated in the base material 40.

The base-containing sheet 6 has a thickness T6 which is not particularly limited but is preferably greater than or equal to 30 µm and less than or equal to 600 µm, and more preferably greater than or equal to 50 µm and less than or equal to 400 µm.

### «Metal Foil»

The metal foil 8 can form the external conductor 7. Examples of the metal foil 8 include, but are not particularly limited to, a copper foil. The metal foil 8 has a thickness T8 substantially equal to the thickness T7 of the external conductor 7.

### <Step (B1)>

As shown in FIG. 2, the laminated body 10 is heated and compressed between hot plates 9 to be integrally laminated.

A heating temperature is preferably a temperature at which the first baseless film 51 and the semi-cured resin layer 61 of the base-containing sheet 6 melt but the second baseless film 52 does not melt. Specifically, the heating temperature is preferably higher than or equal to 180°C and lower than or equal to 220°C, and more preferably higher than or equal to 190°C and lower than or equal to 210°C.

A pressure for integrating the laminated body is preferably greater than or equal to 1.0 MPa and less than or equal to 3.0 MPa, and more preferably greater than or equal to 1.5 MPa and less than or equal to 2.0 MPa.

The amount of time for integrating the laminated body is preferably longer than or equal to 45 minutes and shorter than or equal to 180 minutes, and more preferably longer than or equal to 60 minutes and shorter than or equal to 120 minutes.

In the step (B1), the first baseless film 51 is heated and melted, and while the first baseless film 51 fills the gap between the conductors 212 of the printed wiring board 21, a curing reaction advances, so that the first baseless film 51 becomes the first baseless insulating layer 31.

Further, the second baseless film 52 does not melt, and while the second baseless film 52 follows a flow of a melted resin of the first baseless film 51 and a melted resin of the semi-cured resin layer 61 of the base-containing sheet 6, the second baseless film 52 keeps its initial shape as a film and becomes the second baseless insulating layer 32. Since the second baseless film 52 is disposed between the first baseless film 51 and the base-containing sheet 6, the second baseless film 52 can suppress the melted resin of the first baseless film 51 and the melted resin of the semi-cured resin layer 61 of the base-containing sheet 6 from being mixed with each other.

Further, after completion of the step (B1), the base-containing sheet 6 is the base-containing insulating layer 4. Specifically, in the step (B1), the semi-cured resin layer 61 of the base-containing sheet 6 is heated and melted and a curing reaction advances, so that the semi-cured resin layer 61 becomes the cured resin layer 41 of the base-containing insulating layer 4.

Thus, the thick conductor built-in type printed wiring board 1 shown in FIG. 3 is obtained.

### <Step (C1)>

As necessary, an unnecessary portion(s) of the metal foil 8 is removed to form the external conductor 7. The external conductor 7 may be formed by, for example, a subtractive method. Thus, the thick conductor built-in type printed wiring board 1 shown in FIG. 1 is obtained.

### <Operation and Advantages>

As shown in FIG. 2, according to the present embodiment, collective lamination compression enables the thick conductor built-in type printed wiring board 1 to be easily manufactured. This can reduce costs and save energy.

### (1.3) Variations

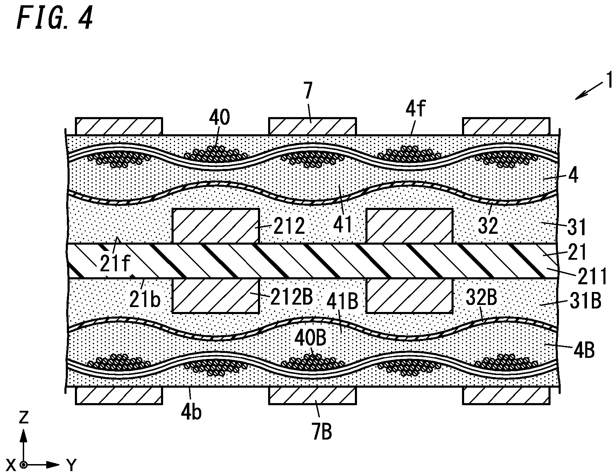

Next, a thick conductor built-in type printed wiring board 1 according to a variation of the present embodiment will be described with reference to FIG. 4.

The thick conductor built-in type printed wiring board 1 according to the variation shown in FIG. 4 is different from the thick conductor built-in type printed wiring board 1 shown in FIG. 1 in that conductors 212B, a first baseless insulating layer 31B, a second baseless insulating layer 32B, a base-containing insulating layer 4B, and an external conductor(s) 7B are further provided.

The conductors 212B are the same as the conductors 212 except that the conductors 212B are disposed on the other surface 21b (the lower surface 21b) in the thickness direction of the insulating layer 211.

The first baseless insulating layer 31B is the same as the first baseless insulating layer 31 except that the first baseless insulating layer 31B covers the lower surface 21b of the insulating layer 211 and the conductors 212B.

The second baseless insulating layer 32B is the same as the second baseless insulating layer 32 except that the second baseless insulating layer 32B covers the first baseless insulating layer 31B.

The base-containing insulating layer 4B is the same as the base-containing insulating layer 4 except that the base-containing insulating layer 4B covers the second baseless insulating layer 32B.

The external conductor 7B is the same as the external conductor 7 except that the external conductor 7B is disposed on an opposite surface 4b (a lower surface 4b) of the base-containing insulating layer 4B from the second baseless insulating layer 32B.

### <Operation and Advantages>

The thick conductor built-in type printed wiring board 1 according to the variation shown in FIG. 4 also provides operation and advantages similar to those of the thick conductor built-in type printed wiring board 1 shown in FIG. 1. Further, in the variation, the second baseless insulating layer 32B is disposed between a base material 40B and the conductors 212B as shown in FIG. 4. Thus, the second baseless insulating layer 32B blocks contact between the base material 40B and the conductors 212B. That is, the cloth touch is suppressed from occurring.

Thus, the thick conductor built-in type printed wiring board 1 according to the variation enables the electrical insulation property in the thickness direction (the Z-axis direction) as well as the electrical insulation property in the planar direction (X-Y plane direction) to be improved.

The second baseless insulating layer 32B further blocks the contact between the first baseless insulating layer 31B and a cured resin layer 41B of the base-containing insulating layer 4B, and therefore, the thick conductor built-in type printed wiring board 1 can have a reduced plate thickness deviation and suppressed color unevenness.

Furthermore, the thick conductor built-in type printed wiring board 1 shown in FIG. 4 further includes the conductors 212B and the external conductor 7B and can thus be further multilayered as compared with the thick conductor built-in type printed wiring board 1 shown in FIG. 1.

### (2) Second Embodiment

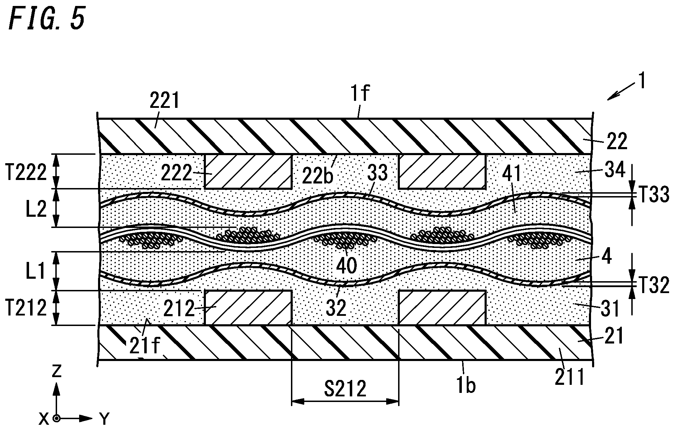

Next, a thick conductor built-in type printed wiring board 1 according to a second embodiment will be described with reference to FIG. 5. In the second embodiment, components similar to those of the first embodiment are denoted by the same reference signs as those in the first embodiment, and the detailed description thereof may be omitted.

### (2.1) Thick Conductor Built-In Type Printed Wiring Board

As shown in FIG. 5, the thick conductor built-in type printed wiring board 1 includes a first printed wiring board 21, a first baseless insulating layer 31, a second baseless insulating layer 32, a base-containing insulating layer 4, a third baseless insulating layer 33, a fourth baseless insulating layer 34, and a second printed wiring board 22. Note that an external conductor(s) (not shown) may be formed on an upper surface 1f and/or a lower surface 1b of the thick conductor built-in type printed wiring board 1. The first printed wiring board 21, the first baseless insulating layer 31, the second baseless insulating layer 32, the base-containing insulating layer 4, the third baseless insulating layer 33, the fourth baseless insulating layer 34, and the second printed wiring board 22 will be sequentially described below.

### <First Printed Wiring Board>

The first printed wiring board 21 is similar to the printed wiring board 21 of the first embodiment. That is, a first insulating layer 211 and first conductors 212 are respectively similar to the insulating layer 211 and the conductors 212 of the first embodiment.

### <First Baseless Insulating Layer>

The first baseless insulating layer 31 is similar to the first baseless insulating layer 31 of the first embodiment.

### <Second Baseless Insulating Layer>

The second baseless insulating layer 32 is similar to the second baseless insulating layer 32 of the first embodiment.

### <Base-Containing Insulating Layer>

The base-containing insulating layer 4 is similar to the base-containing insulating layer 4 of the first embodiment.

### <Third Baseless Insulating Layer>

The third baseless insulating layer 33 is formed from the same material as the second baseless insulating layer 32. That is, the third baseless insulating layer 33 is a layer including no base material and having an electrical insulation property.

The third baseless insulating layer 33 does not have a melting point of lower than or equal to 230°C similarly to the second baseless insulating layer 32. In other words, the third baseless insulating layer 33 does not have to have a fixed melting point or may have a melting point of higher than 230°C.

When the third baseless insulating layer 33 has a fixed melting point, the melting point of the third baseless insulating layer 33 is higher than or equal to 230°C, preferably higher than or equal to 230°C and lower than or equal to 400°C similarly to the melting point of the second baseless insulating layer 32.

The third baseless insulating layer 33 has a thickness T33 of greater than or equal to 3 µm and less than or equal to 25 µm, preferably greater than or equal to 10 µm and less than or equal to 25 µm similarly to a thickness T32 of the second baseless insulating layer 32.

The third baseless insulating layer 33 preferably includes at least one selected from the group consisting of polyimide, aramid (aromatic polyamide), and polyphenylene sulfide similarly to the second baseless insulating layer 32.

The third baseless insulating layer 33 covers the base-containing insulating layer 4. The third baseless insulating layer 33 faces a base material 40 via a cured resin layer 41 in the thickness direction. The cured resin layer 41 does not have to be present between the third baseless insulating layer 33 and the base material 40. In other words, the third baseless insulating layer 33 may be in contact with the base material 40.

### <Fourth Baseless Insulating Layer>

The fourth baseless insulating layer 34 is formed from the same material as the first baseless insulating layer 31. That is, the fourth baseless insulating layer 34 is a layer including no base material and having an electrical insulation property. The fourth baseless insulating layer 34 covers the third baseless insulating layer 33.

### <Second Printed Wiring Board>

The second printed wiring board 22 is formed from the same material as the first printed wiring board 21. The second printed wiring board 22 includes a second insulating layer 221 and second conductors 222.

The second conductors 222 are disposed on a surface 22b (a lower surface 22b) of the second insulating layer 221, the surface 22b facing the fourth baseless insulating layer 34. The second conductors 222 form a circuit. The pattern of the circuit in plan view is not particularly limited. The pattern of the circuit formed by the second conductors 222 may be the same as, or different from, the pattern of the circuit formed by the first conductors 212.

The lower surface 22b of the second insulating layer 221 and the second conductors 222 cover the fourth baseless insulating layer 34. The second conductors 222 are buried in the fourth baseless insulating layer 34. The fourth baseless insulating layer 34 fills a gap between the second conductors 222.

The second conductors 222 face the third baseless insulating layer 33 via the fourth baseless insulating layer 34 in the thickness direction. The fourth baseless insulating layer 34 does not have to be present between the third baseless insulating layer 33 and the second conductors 222. In other words, the second conductors 222 may be in contact with the third baseless insulating layer 33.

Each second conductor 222 has a thickness T222 of greater than or equal to 100 µm and less than or equal to 500 µm, preferably greater than or equal to 175 µm and less than or equal to 420 µm similarly to a thickness T212 of each first conductor 212.

A distance L2 in the thickness direction between each second conductor 222 and the base material 40 included in the base-containing insulating layer 4 is preferably greater than or equal to 3 µm, more preferably greater than or equal to 10 µm similarly to a distance L1 in the thickness direction between each first conductor 212 and the base material 40. An upper limit value of the distance L2 is not particularly limited but is, for example, less than or equal to 400 µm.

### <Operation and Advantages>

The second embodiment also provides operation and advantages similar to those of the first embodiment. That is, the thick conductor built-in type printed wiring board 1 according to the present embodiment includes the second baseless insulating layer 32 disposed between the base material 40 and the first conductors 212 as shown in FIG. 5. Moreover, the third baseless insulating layer 33 is disposed between the base material 40 and the second conductors 222. Thus, the second baseless insulating layer 32 blocks contact between the base material 40 and the first conductors 212, and the third baseless insulating layer 33 blocks contact between the base material 40 and the second conductors 222 and. That is, the cloth touch is suppressed from occurring.

Thus, the present embodiment enables an electrical insulation property in a thickness direction (Z-axis direction) as well as an electrical insulation property in a planar direction (X-Y plane direction) to be improved.

Further, the second baseless insulating layer 32 blocks contact between the first baseless insulating layer 31 and the cured resin layer 41 of the base-containing insulating layer 4. Furthermore, the third baseless insulating layer 33 blocks contact between the fourth baseless insulating layer 34 and the cured resin layer 41 of the base-containing insulating layer 4. Thus, the thick conductor built-in type printed wiring board 1 can have a reduced plate thickness deviation and suppressed color unevenness.

### (2.2) Method for Manufacturing Thick Conductor Built-in Type Printed Wiring Board

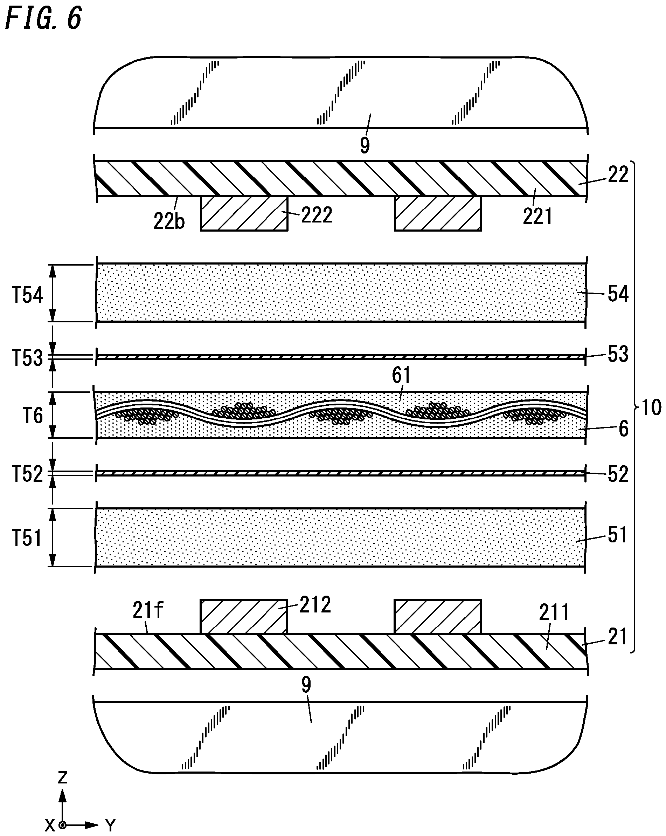

Next, a method for manufacturing the thick conductor built-in type printed wiring board 1 according to the present embodiment will be described with reference to FIG. 6.

The method for manufacturing the thick conductor built-in type printed wiring board 1 includes a step (A2) and a step (B2).

### <Step (A2)>

As shown in FIG. 6, a first baseless film 51, a second baseless film 52, a base-containing sheet 6, a third baseless film 53, a fourth baseless film 54, and the second printed wiring board 22 are overlapped on the first printed wiring board 21 to form a laminated body 10. The first printed wiring board 21, the first baseless film 51, the second baseless film 52, the base-containing sheet 6, the third baseless film 53, the fourth baseless film 54, and the second printed wiring board 22 will be sequentially described below.

### <<First Printed Wiring Board>>

The first printed wiring board 21 has already been described. As shown in FIG. 6, an upper surface 21f of the first printed wiring board 21 is disposed to face the first baseless film 51. That is, in the step (A2), the upper surface 21f of the first insulating layer 211 of the first printed wiring board 21 and the first conductors 212 are disposed to face the first baseless film 51.

### <<First Baseless Film>>

The first baseless film 51 is similar to the first baseless film 51 of the first embodiment.

### <<Second Baseless Film>>

The second baseless film 52 is similar to the second baseless film 52 of the first embodiment.

### <<Base-Containing Sheet>>

The base-containing sheet 6 is similar to the base-containing sheet 6 of the first embodiment.

### <<Third Baseless Film>>

The third baseless film 53 is a film for forming the third baseless insulating layer 33. Thus, the third baseless film 53 includes no base material. Moreover, the third baseless film 53 does not have a melting point of lower than or equal to 230°C similarly to the second baseless film 52. In other words, the third baseless film 53 does not have to have a fixed melting point or may have a melting point of higher than 230°C.

The third baseless film 53 is formed from the same material as the second baseless film 52. That is, when the third baseless film 53 has a melting point of higher than 230°C, the melting point of the third baseless film 53 is preferably higher than 230°C and lower than or equal to 400°C similarly to the melting point of the second baseless film 52.

The third baseless film 53 has a thickness T53 of greater than or equal to 3 µm and less than or equal to 25 µm, preferably greater than or equal to 10 µm and less than or equal to 25 µm similarly to the second baseless film 52. Thus, as long as the third baseless film 53 is not heated at a temperature higher than or equal to the melting point, the thickness T53 of the third baseless film 53 is substantially equal to a thickness T33 of the third baseless insulating layer 33.

### <<Fourth Baseless Film>>

The fourth baseless film 54 is a film for forming the fourth baseless insulating layer 34. Thus, the fourth baseless film 54 includes no base material. The fourth baseless film 54 is formed from the same material as the first baseless film 51.

The fourth baseless film 54 has a thickness T54 of preferably greater than or equal to "the thickness T222 of the second conductor 222 × (1 - residual copper rate)" µm and less than or equal to "the thickness T222 of the second conductor 222" µm, more preferably greater than or equal to "the thickness T222 of the second conductor 222 × (1 - residual copper rate) × 1.2" µm and less than or equal to "the thickness T222 of the second conductor 222" µm, depending on the thickness T222 of each second conductor 222. Note that the residual copper rate = (the area of a pattern of a circuit formed by the second conductors 222 in plan view/the area of the second printed wiring board 22 in plan view).

### <<Second Printed Wiring Board>>

The second printed wiring board 22 has already been described. As shown in FIG. 6, the lower surface 22b of the second printed wiring board 22 is disposed to face the fourth baseless film 54. That is, in the step (A2), the lower surface 22b of the second insulating layer 221 of the second printed wiring board 22 and the second conductors 222 are disposed to face the fourth baseless film 54.

### <Step (B2)>

As shown in FIG. 6, the laminated body 10 is heated and compressed between hot plates 9 to be integrally laminated. A heating temperature and pressure and the amount of time for integrating the laminated body are similar to the heating temperature and the pressure and the amount of time for integrating the laminated body in the first embodiment.

In the step (B2), the first baseless film 51 is heated and melted, and while the first baseless film 51 fills the gap between the first conductors 212 of the first printed wiring board 21, a curing reaction advances, and the first baseless film 51 becomes the first baseless insulating layer 31.

Further, the second baseless film 52 does not melt, and while the second baseless film 52 follows a flow of a melted resin of the first baseless film 51 and a melted resin of a semi-cured resin layer 61 of the base-containing sheet 6, the second baseless film 52 keeps its initial shape as a film and becomes the second baseless insulating layer 32. Since the second baseless film 52 is disposed between the first baseless film 51 and the base-containing sheet 6, the second baseless film 52 can suppress the melted resin of the first baseless film 51 and the melted resin of the semi-cured resin layer 61 of the base-containing sheet 6 from being mixed with each other.

Further, after completion of the step (B2), the base-containing sheet 6 is the base-containing insulating layer 4. Specifically, in the step (B2), the semi-cured resin layer 61 of the base-containing sheet 6 is heated and melted, a curing reaction advances, and the semi-cured resin layer 61 becomes the cured resin layer 41 of the base-containing insulating layer 4.

Further, the third baseless film 53 does not melt, and while the third baseless film 53 follows a flow of a melted resin of the fourth baseless film 54 and a melted resin of the semi-cured resin layer 61 of the base-containing sheet 6, the third baseless film 53 keeps its initial shape as a film and becomes the third baseless insulating layer 33. Since the third baseless film 53 is disposed between the fourth baseless film 54 and the base-containing sheet 6, the third baseless film 53 can suppress the melted resin of the fourth baseless film 54 and the melted resin of the semi-cured resin layer 61 of the base-containing sheet 6 from being mixed with each other.

Further, the fourth baseless film 54 is heated and melted, and while the fourth baseless film 54 fills the gap between the second conductors 222 of the second printed wiring board 22, a curing reaction advances, and the fourth baseless film 54 becomes the fourth baseless insulating layer 34.

Thus, the thick conductor built-in type printed wiring board 1 shown in FIG. 5 is obtained. Note that an external conductor(s) (not shown) may be formed on the upper surface 1f and/or the lower surface 1b of the thick conductor built-in type printed wiring board 1 by an additive method.

### <Operation and Advantages>

As shown in FIG. 6, according to the present embodiment, collective lamination compression enables the thick conductor built-in type printed wiring board 1 to be easily manufactured. This can reduce costs and save energy.

### 3. Aspects

As can be seen from the embodiments described above, the present disclosure includes aspects described below. In the following description, reference signs in parentheses are added only to clearly show the correspondence relationship to the embodiments.

A first aspect is a thick conductor built-in type printed wiring board (1) including: a printed wiring board (21) including an insulating layer (211) and a conductor (212) disposed on one surface in a thickness direction of the insulating layer (211) and having a thickness (T212) of greater than or equal to 100 µm and less than or equal to 500 µm; a first baseless insulating layer (31) covering the insulating layer (211) and the conductor (212) and including no base material; a second baseless insulating layer (32) covering the first baseless insulating layer (31), including no base material, not having a melting point of lower than or equal to 230°C, and having a thickness (T32) of greater than or equal to 3 µm and less than or equal to 25 µm; and a base-containing insulating layer (4) covering the second baseless insulating layer (32) and including a base material (40).

This aspect enables a cloth touch to be suppressed from occurring and enables an electrical insulation property in a thickness direction as well as an electrical insulation property in a planar direction to be improved.

A second aspect is a thick conductor built-in type printed wiring board (1) based on the first aspect. The second aspect further includes an external conductor (7) disposed on an opposite surface of the base-containing insulating layer (4) from the second baseless insulating layer (32).

This aspect enables the thick conductor built-in type printed wiring board (1) to be multilayered.

A third aspect is a thick conductor built-in type printed wiring board (1) based on the first or second aspect. In the third aspect, a distance (L1) in the thickness direction between the conductor (212) and the base material (40) included in the base-containing insulating layer (4) is greater than or equal to 3 µm.

This aspect further suppresses the cloth touch from occurring. That is, the chances that the base material (40) comes into contact with the conductor (212) are reduced. This suppresses a path for a current from being formed.

A fourth aspect is a thick conductor built-in type printed wiring board (1) based on any one of the first to third aspects. In the fourth aspect, the second baseless insulating layer (32) includes at least one selected from the group consisting of polyimide, aramid, and polyphenylene sulfide.

With this aspect, even when the second baseless insulating layer (32) is a thin film having a thickness (T32) of less than or equal to 25 µm, the second baseless insulating layer (32) is strong and has an enhanced electrical insulation property.

A fifth aspect is a thick conductor built-in type printed wiring board (1) including: a first printed wiring board (21) including a first insulating layer (211) and a first conductor (212) disposed on one surface in a thickness direction of the first insulating layer (211) and having a thickness (T212) of greater than or equal to 100 µm and less than or equal to 500 µm; a first baseless insulating layer (31) covering the first insulating layer (211) and the first conductor (212) and including no base material; a second baseless insulating layer (32) covering the first baseless insulating layer (31), including no base material, not having a melting point of lower than or equal to 230°C, and having a thickness (T32) of greater than or equal to 3 µm and less than or equal to 25 µm; a base-containing insulating layer (4) covering the second baseless insulating layer (32) and including a base material (40); a third baseless insulating layer (33) covering the base-containing insulating layer (4), including no base material, not having a melting point of lower than or equal to 230°C, and having a thickness (T33) of greater than or equal to 3 µm and less than or equal to 25 µm; a fourth baseless insulating layer (34) covering the third baseless insulating layer (33) and including no base material; and a second printed wiring board (22) including a second insulating layer (221) covered with the fourth baseless insulating layer (34) and a second conductor (222) disposed on a surface of the second insulating layer (221), the surface facing the fourth baseless insulating layer (34), the second conductor (222) being covered with the fourth baseless insulating layer (34) and having a thickness (T222) of greater than or equal to 100 µm and less than or equal to 500 µm.

This aspect enables a cloth touch to be suppressed from occurring and enables an electrical insulation property in a thickness direction as well as an electrical insulation property in a planar direction to be improved.

A sixth aspect is a thick conductor built-in type printed wiring board (1) based on the fifth aspect. In the sixth aspect, the second baseless insulating layer (32) and/or the third baseless insulating layer (33) includes at least one selected from the group consisting of polyimide, aramid, and polyphenylene sulfide.

With this aspect, even when the second baseless insulating layer (32) is a thin film having a thickness (T32) of less than or equal to 25 µm, the second baseless insulating layer (32) is strong and has an enhanced electrical insulation property. Similarly, even when the third baseless insulating layer (33) is a thin film having a thickness (T33) of less than or equal to 25 µm, the third baseless insulating layer (33) is strong and has an enhanced electrical insulation property.

A seventh aspect is a thick conductor built-in type printed wiring board (1) based on the fifth or sixth aspect. In the seventh aspect, a distance (L1) in the thickness direction between the first conductor (212) and the base material (40) included in the base-containing insulating layer (4) and/or a distance (L2) in the thickness direction between the second conductor (222) and the base material (40) included in the base-containing insulating layer (4) is greater than or equal to 3 µm.

This aspect further suppresses the cloth touch from occurring. That is, the chances that the base material (40) comes into contact with the first conductor (212) are reduced. Similarly, the chances that the base material (40) comes into contact with the second conductor (222) are reduced. This suppresses a path for a current from being formed.

An eighth aspect is a method for manufacturing a thick conductor built-in type printed wiring board (1), the method including: a step (A1) of overlapping a first baseless film (51) including no base material, a second baseless film (52) including no base material, not having a melting point of lower than or equal to 230°C, and having a thickness (T52) of greater than or equal to 3 µm and less than or equal to 25 µm, a base-containing sheet (6) including a base material (40), and a metal foil (8) in this order on a printed wiring board (21) to form a laminated body (10); and a step (B1) of integrating the laminated body (10) by heating and compressing the laminated body (10) disposed between hot plates (9). The printed wiring board (21) includes an insulating layer (211) and a conductor (212) disposed on one surface in a thickness direction of the insulating layer (211) and having a thickness (T212) of greater than or equal to 100 µm and less than or equal to 500 µm. In the step (A1), the insulating layer (211) of the printed wiring board (21) and the conductor (212) are disposed to face the first baseless film (51).

This aspect enables a cloth touch to be suppressed from occurring and enables an electrical insulation property in a thickness direction as well as an electrical insulation property in a planar direction to be improved.

A ninth aspect is a method for manufacturing the thick conductor built-in type printed wiring board (1) based on the eighth aspect. The ninth aspect further includes a step (C1) of removing an unnecessary portion of the metal foil (8) to form an external conductor (7).

This aspect enables the thick conductor built-in type printed wiring board (1) to be multilayered.

A tenth aspect is a method for manufacturing a thick conductor built-in type printed wiring board (1), the method comprising: a step (A2) of overlapping, on a first printed wiring board (21), a first baseless film (51) including no base material, a second baseless film (52) including no base material, not having a melting point of lower than or equal to 230°C, and having a thickness (T52) of greater than or equal to 3 µm and less than or equal to 25 µm, a base-containing sheet (6) including a base material (40), a third baseless film (53) including no base material, not having a melting point of lower than or equal to 230°C, and having a thickness (T53) of greater than or equal to 3 µm and less than or equal to 25 µm, a fourth baseless film (54) including no base material, and a second printed wiring board (22) in this order to form a laminated body (10); and a step (B2) of integrating the laminated body (10) by heating and compressing the laminated body (10) disposed between hot plates (9). The first printed wiring board (21) includes a first insulating layer (211) and a first conductor (212) disposed on one surface in a thickness direction of the first insulating layer (211) and having a thickness (T212) of greater than or equal to 100 µm and less than or equal to 500 µm. The second printed wiring board (22) includes a second insulating layer (221) and a second conductor (222) disposed on one surface in a thickness direction of the second insulating layer (221) and having a thickness (T222) of greater than or equal to 100 µm and less than or equal to 500 µm. In the step (A2), the first insulating layer (211) of the first printed wiring board (21) and the first conductor (212) are disposed to face the first baseless film (51), and the second insulating layer (221) of the second printed wiring board (22) and the second conductor (222) are disposed to face the fourth baseless film (54).

This aspect enables a cloth touch to be suppressed from occurring and enables an electrical insulation property in a thickness direction as well as an electrical insulation property in a planar direction to be improved.

### Examples

The present disclosure will specifically be described below with reference to examples. Note that the present disclosure is not limited to the examples.

### 1. Samples

For each of Examples 1 to 4 and Comparative Examples 1 and 2, five samples of each of two types were manufactured (n = 5, size 60 mm × 60 mm in plan view), the samples each corresponding to the thick conductor built-in type printed wiring board 1 shown in FIG. 1. The two types of samples are different in terms of the L/S of the printed wiring board 21. That is, the L/S of a first sample is 1.25 mm/2.5 mm, and the L/S of a second sample is 1.25 mm/1.25 mm.

A material for the conductors 212 of the printed wiring board 21 is copper. The thickness T212 of each conductor 212 is shown in Table 1. Note that the printed wiring board 21 was obtained by processing a material, under the product name "R-1566S", manufactured by Panasonic Corporation.

As the first baseless film 51, a material, under the product name "CV2008", manufactured by Panasonic Corporation, was used. The thickness T51 of the first baseless film 51 is shown in Table 1.

As the second baseless film 52, a polyimide film (manufactured by DU PONT-TORAY CO., LTD., product name "Kapton 50EN"), an aramid film (manufactured by Toray Industries, Inc., product name "Mictron 4Y-GE2"), and a polyphenylene sulfide (PPS) film (manufactured by Toray Industries, Inc., product name "Torelina") were used. Each of these products does not have a melting point of lower than or equal to 230°C. The thickness T52 of the second baseless film 52 is shown in Table 1.

As the base-containing sheet 6, a prepreg (manufactured by Panasonic Corporation, product name "R-1551S(G)", glass cloth style #1080, 70% resin content) was used. The thickness of the base-containing sheet 6 and the number of used base-containing sheets 6 are shown in Table 1.

Samples of Examples 1 to 4 were manufactured as described below. That is, as shown in FIG. 2, the first baseless film 51, the second baseless film 52, the base-containing sheet 6, and the metal foil 8 were overlapped in this order on the printed wiring board 21 to form the laminated body 10, and the laminated body 10 was heated and compressed between the hot plates 9 to be integrally laminated. A heating temperature was 200°C, pressure was 1.5 MPa, and the amount of time was 60 minutes.

The sample of Comparative Example 1 was produced in a similar manner to the sample of each Example except that no second baseless film 52 was used.

The sample of Comparative Example 2 was manufactured in a similar manner to the sample of each Example except for that the first baseless film 51 and the second baseless film 52 were not used.

### 2. Evaluation

### (1) Dielectric Breakdown Voltage

It can be inferred that the electrical insulation property in the thickness direction of each of the above-described samples is strongly influenced by electrical insulation properties of the second baseless insulating layer and the base-containing insulating layer.

Therefore, for each of Example 1 to 4, a second baseless film (one sheet) and a base-containing sheet (one sheet) shown in Table 1 were overlapped on top of one another and heated and compressed to be integrally laminated, thereby five test specimens were produced (n = 5). The heating temperature was 200°C, the pressure was 2.0 MPa, and the amount of time was 90 minutes.

For Comparative Example 1, five test specimens were manufactured in a similar manner to each Example except for that no second baseless film was used (n = 5).

For Comparative Example 2, five test specimens were manufactured in a similar manner to each Example except for that no second baseless film was used and four base-containing sheets were used (n = 5).

Dielectric breakdown voltages (dielectric strength) of the test specimens were measured based on ASTM D149. Measured values were classified based on the following evaluation criteria.
A: Greater than or equal to 10 kV
B: Less than 10 kV

### (2) Filling Property

The cross section of each sample was observed by using a digital microscope (manufactured by KEYENCE CORPORATION, model "VH-Z500"). The presence or absence of a void was checked, and the diameter (long diameter) of the void was measured by using a measurement function of the digital microscope. Observation results were classified based on the following evaluation criteria.
A: A void having a diameter of more than or equal to 10 µm was observed in neither the first sample nor the second sample.
B: A void having a diameter of more than or equal to 10 µm was observed in the first sample, and no void having a diameter of more than or equal to 10 µm was observed in the second sample.

### (3) Cloth Touch

A cross section of each sample was observed by using a digital microscope similar to the one used above. Results of the observation were classified based on the following criteria.
A: No cloth touch was observed (the conductor and the base material were out of contact with each other)
B: A cloth touch was observed (the conductor and the base material were in contact with each other).

**[Table 1]**

| | | | Example | | | | Comparative Example | |
|---|---|---|---|---|---|---|---|---|
| | | | 1 | 2 | 3 | 4 | 1 | 2 |
| Base-containing Sheet (Prepreg) | Type | - | R-1551S(G) #1080 70% | R-1551S(G) #1080 70% | R-1551S(G) #1080 70% | R-1551S(G) #1080 70% | R-1551S(G) #1080 70% | R-1551S(G) #1080 70% |
| | Single Thickness | µm | 90 | 90 | 90 | 90 | 90 | 90 |
| | The Number of Used Sheets | - | 1 | 1 | 1 | 1 | 1 | 4 |
| | Total Thickness | µm | 90 | 90 | 90 | 90 | 90 | 360 |
| Second Baseless Film | Type | - | Polyimide | Polyimide | Aramid | PPS | - | - |
| | Thickness | µm | 12 | 12 | 4 | 12 | - | - |
| First Baseless Film | Thickness | µm | 150 | 300 | 300 | 300 | 150 | - |
| Conductor | Thickness | µm | 200 | 400 | 400 | 400 | 200 | 200 |
| Distance between Conductor and Base Material (L1) | | µm | 22 | 22 | 14 | 22 | 0 | 0 |
| Dielectric Breakdown Voltage | | | A | A | B | A | B | A |
| Filling Property | | | A | A | A | A | A | B |
| Cloth Touch | | | A | A | A | A | B | B |

### Reference Signs List

- 1: Thick Conductor Built-In Type Printed Wiring Board
- 10: Laminated Body
- 21: First Printed Wiring Board (Printed Wiring Board)
- 211: First Insulating Layer (Insulating Layer)
- 212: First Conductor (Conductor)
- 22: Second Printed Wiring Board
- 221: Second Insulating Layer
- 222: Second Conductor
- 31: First Baseless Insulating Layer
- 32: Second Baseless Insulating Layer
- 33: Third Baseless Insulating Layer
- 34: Fourth Baseless Insulating Layer
- 4: Base-Containing Insulating Layer
- 51: First Baseless Film
- 52: Second Baseless Film
- 53: Third Baseless Film
- 54: Fourth Baseless Film
- 6: Base-Containing Sheet
- 7: External Conductor
- 8: Metal Foil
- 9: Hot Plate
- T212: Thickness
- T222: Thickness
- T32: Thickness
- T33: Thickness
- T52: Thickness
- T53: Thickness
- L1: Distance
- L2: Distance

## Claims

1. A thick conductor built-in type printed wiring board comprising:
a printed wiring board including
an insulating layer and
a conductor disposed on one surface in a thickness direction of the insulating layer and having a thickness of greater than or equal to 100 µm and less than or equal to 500 µm;
a first baseless insulating layer covering the insulating layer and the conductor and including no base material;
a second baseless insulating layer covering the first baseless insulating layer, including no base material, not having a melting point of lower than or equal to 230°C, having a thickness of greater than or equal to 3 µm and less than or equal to 25 µm; and
a base-containing insulating layer covering the second baseless insulating layer and including a base material.

2. The thick conductor built-in type printed wiring board of claim 1, further comprising an external conductor disposed on an opposite surface of the base-containing insulating layer from the second baseless insulating layer.

3. The thick conductor built-in type printed wiring board of claim 1, wherein
a distance in the thickness direction between the conductor and the base material included in the base-containing insulating layer is greater than or equal to 3 µm.

4. The thick conductor built-in type printed wiring board of any one of claims 1 to 3, wherein
the second baseless insulating layer includes at least one selected from the group consisting of polyimide, aramid, and polyphenylene sulfide.

5. A thick conductor built-in type printed wiring board comprising:
a first printed wiring board including
a first insulating layer and
a first conductor disposed on one surface in a thickness direction of the first insulating layer and having a thickness of greater than or equal to 100 µm and less than or equal to 500 µm;
a first baseless insulating layer covering the first insulating layer and the first conductor and including no base material;
a second baseless insulating layer covering the first baseless insulating layer, including no base material, not having a melting point of lower than or equal to 230°C, and having a thickness of greater than or equal to 3 µm and less than or equal to 25 µm;
a base-containing insulating layer covering the second baseless insulating layer and including a base material;
a third baseless insulating layer covering the base-containing insulating layer, including no base material, not having a melting point of lower than or equal to 230°C, and having a thickness of greater than or equal to 3 µm and less than or equal to 25 µm;
a fourth baseless insulating layer covering the third baseless insulating layer and including no base material; and
a second printed wiring board including
a second insulating layer covered with the fourth baseless insulating layer and
a second conductor disposed on a surface of the second insulating layer, the surface facing the fourth baseless insulating layer, the second conductor being covered with the fourth baseless insulating layer and having a thickness of greater than or equal to 100 µm and less than or equal to 500 µm.

6. The thick conductor built-in type printed wiring board of claim 5, wherein
the second baseless insulating layer and/or the third baseless insulating layer includes at least one selected from the group consisting of polyimide, aramid, and polyphenylene sulfide.

7. The thick conductor built-in type printed wiring board of claim 5 or 6, wherein
a distance in the thickness direction between the first conductor and the base material included in the base-containing insulating layer and/or a distance in the thickness direction between the second conductor and the base material included in the base-containing insulating layer is greater than or equal to 3 µm.

8. A method for manufacturing a thick conductor built-in type printed wiring board, the method comprising:
a step (A1) of overlapping a first baseless film including no base material, a second baseless film including no base material, not having a melting point of lower than or equal to 230°C, and having a thickness of greater than or equal to 3 µm and less than or equal to 25 µm, a base-containing sheet including a base material, and a metal foil in this order on a printed wiring board to form a laminated body; and
a step (B 1) of integrating the laminated body by heating and compressing the laminated body disposed between hot plates,
the printed wiring board including
an insulating layer and
a conductor disposed on one surface in a thickness direction of the insulating layer and having a thickness of greater than or equal to 100 µm and less than or equal to 500 µm,
in the step (A1), the insulating layer of the printed wiring board and the conductor being disposed to face the first baseless film.

9. The method of claim 8, further comprising a step (C1) of removing an unnecessary portion of the metal foil to form an external conductor.

10. A method for manufacturing a thick conductor built-in type printed wiring board, the method comprising:
a step (A2) of overlapping, on a first printed wiring board, a first baseless film including no base material, a second baseless film including no base material, not having a melting point of lower than or equal to 230°C, and having a thickness of greater than or equal to 3 µm and less than or equal to 25 µm, a base-containing sheet including a base material, a third baseless film including no base material, not having a melting point of lower than or equal to 230°C, and having a thickness of greater than or equal to 3 µm and less than or equal to 25 µm, a fourth baseless film including no base material, and a second printed wiring board in this order to form a laminated body; and
a step (B2) of integrating the laminated body by heating and compressing the laminated body disposed between hot plates,
the first printed wiring board including
a first insulating layer and
a first conductor disposed on one surface in a thickness direction of the first insulating layer and having a thickness of greater than or equal to 100 µm and less than or equal to 500 µm,
the second printed wiring board including
a second insulating layer and
a second conductor disposed on one surface in a thickness direction of the second insulating layer and having a thickness of greater than or equal to 100 µm and less than or equal to 500 µm,
in the step (A2), the first insulating layer of the first printed wiring board and the first conductor being disposed to face the first baseless film, the second insulating layer of the second printed wiring board and the second conductor being disposed to face the fourth baseless film.
